Europäisches Patentamt

European Patent Office

Office européen des brevets

(11) Publication number: **0 378 815**
**A2**

## (12) EUROPEAN PATENT APPLICATION

(21) Application number: **89123167.2**

(51) Int. Cl.⁵: **C23C 16/54, H01L 21/00**

(22) Date of filing: **14.12.89**

| | |
|---|---|
| The title of the invention has been amended (Guidelines for Examination in the EPO, A-III, 7.3). | **Dallas Texas 75265(US)** |
| | (72) Inventor: **Ishii, Kaoru** |
| (30) Priority: **20.12.88 US 287174** | **3201 Cross Timbers** |
| **20.12.88 US 287106** | **Garland Texas 75042(US)** |
| **20.12.88 US 287171** | Inventor: **Wilkinson, Thomas F.** |
| **20.12.88 US 287418** | **1617 McDonald Drive** |
| | **Garland Texas 75041(US)** |
| (43) Date of publication of application: | Inventor: **Moroi, Masayuki** |
| **25.07.90 Bulletin 90/30** | **665-30 Nakanuki** |
| | **Tsuchiura-Shi Ibaraki-Precture 300(JP)** |
| (84) Designated Contracting States: | |
| **DE FR GB IT NL** | (74) Representative: **Leiser, Gottfried, Dipl.-Ing. et al** |
| (71) Applicant: **TEXAS INSTRUMENTS** | **Patentanwälte Prinz, Leiser, Bunke & Partner** |
| **INCORPORATED** | **Manzingerweg 7** |
| **13500 North Central Expressway** | **D-8000 München 60(DE)** |

(54) **Continuous chemical vapour deposition system.**

(57) A continuous chemical deposition reactor system transfers semiconductor wafers through a reactor having a plurality of process chambers (25). A cassette (20) of wafers is placed for access by a robotic arm (21). Robotic arm (21) lifts wafers from cassette (10) and places them in carriers (22), which move along tracks (33). Junctions (25a) join chambers (25) and allow for introduction and exhaust of process gases. An enclosure (37) surrounds the entire reactor.

Fig.2

EP 0 378 815 A2

## CCVD REACTOR SYSTEMS

### FIELD OF THE INVENTION

This invention relates to continuous chemical vapor deposition reactors, and more particularly to improvements in reactor gas distribution for such reactors.

### BACKGROUND OF THE INVENTION

A continuous chemical deposition reactor may be a stand-alone process system with a continuous semiconductor wafer flow. Basic sybsystems in which a system may include a wafer handling, a reaction chamber, a gas flow system, a cooling system, and an electrical system.

The wafer handling system may include wafer loaders and unloaders, wafer carriers, and a track for moving a wafer through the reactor chambers.

The reactor chamber subsystem is the site for processing the semiconductor wafer. Each chamber may include a gas supply inlet, a chamber housing, heat lamps and exhaust.

The gas flow subsystem supplies the reactant gases to each chamber, and may include valves, flow controllers and an exhaust system.

The cooling subsystem assists in maintaining the process temperature and reduces the heat radiation to the surrounding components. Both air flow and water flow may be used in the cooling subsystem.

The electrical subsystem provides subsystem control and powers the reactor, and may include power supplies motors, sensors, valves, and one or more computer/controller.

A basic reactor and process may be as follows. A semiconductor wafer is loaded onto a carrier which enters one end of the reactor through a port and is moved successively through the various chambers and out the other end of the reactor through another port. The reactor may not be physically closed but has gas seals at each end and in between each chamber of the reactor. As an example, a reactor may include eight chambers in which the first chamber consists of a nitrogen seal, the second chamber is a preheat chamber, the next four chambers may be deposition chambers, then a cool-down chamber and the last chamber is a nitrogen seal. A typical gas supply system may supply gases for two different deposition processes which may be directed into any of the deposition chambers.

A typical gas supply system may supply gases for two different deposition processes which may be directed into any of the deposition chambers.

Each chamber is effectively divided into two portions, a top portion and a bottom portion by the wafer carrier. The junctions between the chambers effectively isolate one chamber from the other by the flow of gases or the exhaust gases from the chambers, and gas flow or seals are used to prevent gases from escaping from the reactor chamber/junction interface.

An example of a prior art continuous chemical vapor deposition reactor may be found in U. S. Patent 4,048,955.

### SUMMARY OF THE INVENTION

The invention relates to a multi-chamber continuous chemical vapor deposition reactor and subsystems therein through which semiconductor wafers may be passed in order to perform etching and various deposition processes thereon.

A wafer carrier track on which the semiconductor wafer carrier is moved through the reactor prevents undo wear on the reaction chamber. The track also is used as part of the divider to divide the reactor chamber into two regions, one region below the semiconductor carrier which is the process region and the top region, above the carrier which is the region through which heat is transmitted from a heating lamp to the carrier. The carrier or carrier lid is used in distributing heat evenly over the semiconductor wafer during processing.

Process gas flow and distribution systems used in the reactor provide better process gas distribution to the reactor chamber and prevent deposition of deposition material on the reaction chamber. Seals and a method of preventing gases from escaping at the reaction chamber/junction interface are provided.

A semiconductor wafer is removed from a wafer cassette by a robotic arm and is placed in a carrier. The carrier, constructed of graphite or graphite coated with silicon carbide may be one of several configurations, and may accommodate one or more semiconductor wafers depending upon the diameter of the wafer. The wafer is placed so that it is face down in the reactor such that all processing of the wafer is done from the underside of the carrier, and a lid, or the carrier itself is placed over the up-side of the semiconductor wafer to prevent process or other gases from reacting with that side, and to provide a uniform heat distribution to the semicondctor during processing.

A semiconductor wafer is placed in the carrier and is moved successively through the various chambers and out the end of the reactor. The semiconductor wafer is placed inverted in the carrier and a lid is placed on top. The lid becomes the susceptor for radiant heat from incandescent lamp heaters.

Each chamber has an associated heat lamp, gas inlets and outlets, tracks on which the wafer carrier is moved. In one embodiment of the invention, round grooves on two sides of the carrier slide on round tracks. The seals prevent the gas from escaping to the environment out side the reactor, and prevent exhaust gases from entering the process chambers, or reaction gases from entering the topside of the reactor chamber. The carrier is also used to block the movement of process gas to the reactor chamber area above the carrier.

The gas inlets may be baffled to cause an even distribution of gas with in the reactor, and to prevent unwanted deposition of material on the reactor chamber wall.

The seal may be a mechanical seal or a pressure differential seal to prevent a gas from entering an area within the reactor or escaping the reactor at points other than the exhaust ports.

Each chamber of the reactor is divided into two regions by the wafer carrier. These two regions are regions above the carrier and below the carrier. The process gas flows through the lower part of the reactor below the carrier and across the exposed semiconductor wafer face. $H_2$, or inert gas may be directed through the upper region of the reactor to prevent the process gas from entering the upper region and to help provide the gas pressure differential needed to prevent exhaust gases from entering the process region of the reactor.

The junction between chambers effectively isolates one chamber from the other by the flow of process gases or the exhaust of gas or gases from the chambers. The interfaces between each junction and the reaction chamber on each side require a seal between the interface to prevent gases from escaping into the room in which the reactor is located. The carrier track has openings through the track at each junction to permit the used process to exhaust through the exhaust port in the junction.

Dividing the gas input and/or providing baffles in the input gas stream smooths out the gas flow in the reactor to provide better deposition on and/or etching of the semiconductor surface. Also, central exhaust ports prevent diagonal gas flow in the reactor which may cause uneven deposition or etch.

By providing a laminar gas flow in the reactor of two different gases, the process gas and $H_2$, or an inert gas, prevents deposition of material on the reaction chamber below the semiconductor wafer.

The technical advance represented by the invention as well as the objects thereof will become apparent from the following description of a preferred embodiment of the invention when considered in conjunction with the accompanying drawings, and the novel features set forth in the appended claims.

## BRIEF DESCRIPTION OF THE DRAWING

Figure 1 is a simplified block diagram of the continuous chemical vapor deposition reactor;

Figure 2 illustrates a typical CCVD reactor of the present invention;

Figure 3 is a cross sectional view of two reaction chambers joined by a junction;

Figure 4 is a cross sectional view of a two reaction chambers and three junctions illustrating the gas flow between junctions;

Figure 5 is the top view of two sections of reaction chambers connected by the chamber junctions;

Figure 5a is a cross-sectional view of an exhaust junction;

Figure 5b is a cross-section view of a gas inlet junction;

Figure 6 illustrates gas flow in a reaction chamber using side gas inlets and side exhaust ports;

Figure 7 illustrates gas flow in a reaction chamber using a side gas inlet and a center exhaust port;

Figure 8 illustrates gas flow in a reaction chamber using a dual baffled gas inlet and a central exhaust port;

Figure 9 illustrates a baffled gas inlet with a shuttered outlet into the reaction chamber;

Figure 10 is a top view of another embodiment of two sections of reaction chambers connected by chamber junctions;

Figure 10a is a cross-sectional view of an exhaust junction with a central exhaust outlet;

Figure 10b is a cross-section view of a gas inlet junction with central gas inlets; and

Figure 11 is a cross sectional view of two reaction chambers connected to chamber junctions illustrating the use of baffles to prevent deposition of deposition products on the reaction chamber below the semiconductor wafer.

Figure 12 illustrates a carrier of the prior art that moves along the bottom of the reaction chamber;

Figure 13 illustrates a track system according to the present invention;

Figure 14 illustrates a second embodiment of a track system of the present invention;

Figure 15 is an isometric drawing illustrating a tubular track system;

Figure 16 is a cross-sectional view of a junction between reactor chambers and shows a carrier on a tubular track and

Figure 17 illustrates carriers in a reactor system separated by spacers.

Figure 18 illustrates a flexible seal used between a reactor chamber and the junction joining two reactor chambers;

Figure 19 illustrates another embodiment of a flexible seal, and

Figure 20 illustrates a seal between a reactor chamber and a junction using gas flow and pressure differentials.

Figure 21 is a side view of a wafer centering device;

Figure 22 is a top view of the wafer centering device of Figure 21;

Figure 23 illustrates a semiconductor pick-up device;

Figure 24 is another illustration of the semiconductor pick-up device of Figure 23;

Figure 25 illustrates one embodiment of a semiconductor carrier that may be used in the reactor of ther present invention ;

Figure 26 is a cross-sectional view of a heating lamp assembly over a reactor chamber.

## DESCRIPTION OF A PREFERRED EMBODIMANT OF THE INVENTION

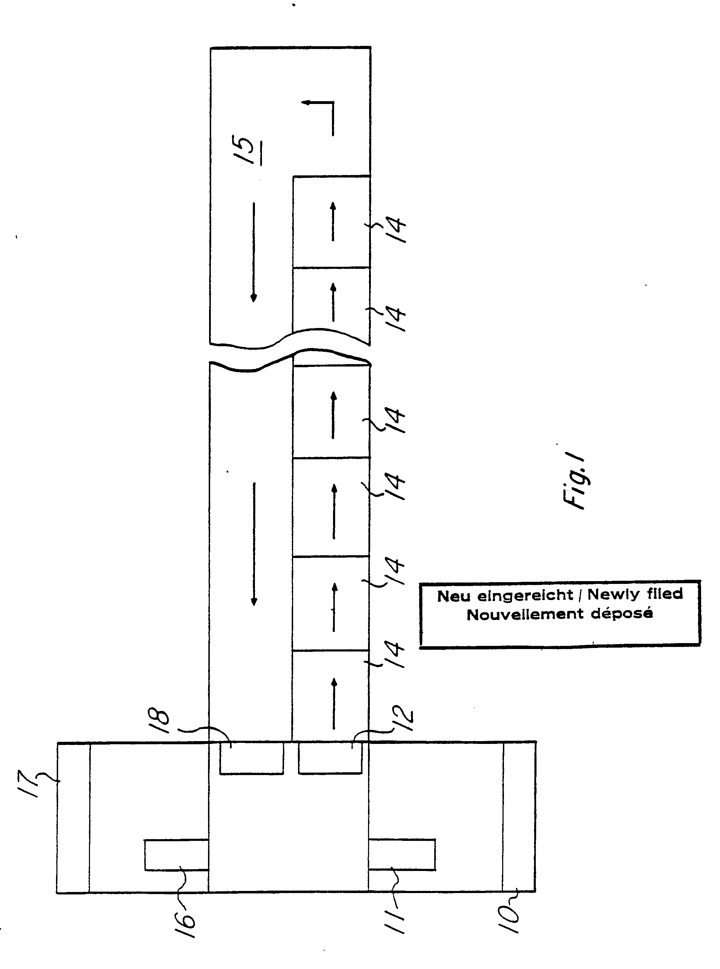

Figure 1 is a block diagram of a reactor of the present invention. Semiconductor wafers that are to be processed are loaded into cassettes 10. A robotic arm 11 removes a wafer from the cassette and places it in a susceptor/carrier which enters the reactor at 12, and then is moved through a plurality of process chambers 14 to the end of the reactor where it enters a return path 15. The semiconductor wafer in the susceptor is moved through return path 15 to an unload station 18. At unload station 18, the wafer is removed from the susceptor by robotic arm 16 and placed in a cassette at 17.

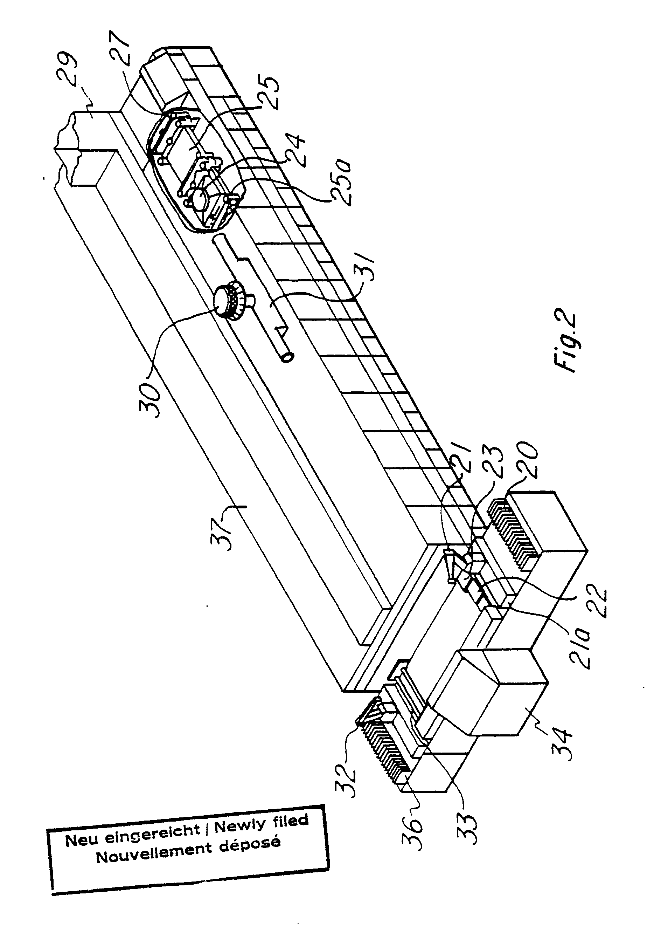

Figure 2 is a more detailed illustration of a continuous chemical vapor deposition reactor. A plurality of wafer cassettes 20 are located along and adjacent to a robotic arm 21 which moves along a track 21a. The track allows the robotic arm 21 to move adjacent each of a plurality of wafer cassettes so as to permit the robotic arm to access each wafer in each cassette. The robotic arm lifts a wafer from a cassette and places it in a carrier 22 at the entrance to the reactor. The entrance 23 to the reactor is a seal joint to prevent gases in the reactor from exiting from the reactor.

At the entrance 23, and before the carrier enters the reactor a vacuum pick-up arm (not illustrated) lifts the lid from the carrier to allow the robotic arm to place a semiconductor wafer into the carrier. After the semiconductor is placed into the carrier the carrier lid is replaced and the carrier is indexed through the reactor and the plurality of chambers that make up the reactor.

The carrier is indexed through the reactor and chambers using the length of the carrier and at least one spacer bar between each carrier. As each carrier is indexed into the reactor, each preceding carrier is moved to the next reactor chamber. The indexing is continuous, and as the carrier exits from the last reaction chamber is moves indexed through the return path of the reactor to the exit opening in the reactor, where the lid of the carrier is removed by the return lid pick-up (not illustrated). Tracks 33, which extend through out the reactor, are used to move the wafer carrier through the reactor. A robotic arm 32 mounded on track 32a removes the semiconductor wafer from the carrier and places it in a wafer cassette 36.

The reactor is divided into a plurality of quartz reactor chambers 25. The reaction chambers 25 are joined by a junction 25a through which is introduced to the process gases and from which the used gases are exhausted.

Positioned over each reaction chamber is a heater block 24, used to heat the reaction chamber to a desired temperature. Water to cool the lamp housing is introduced through the junctions 25a through inlet 26.

Each junction 25a has at least one exhaust tube 27 for removing exhaust gases from the reaction chambers. The exhaust gases are directed through a burn-off tube 31 to the gas burner 30.

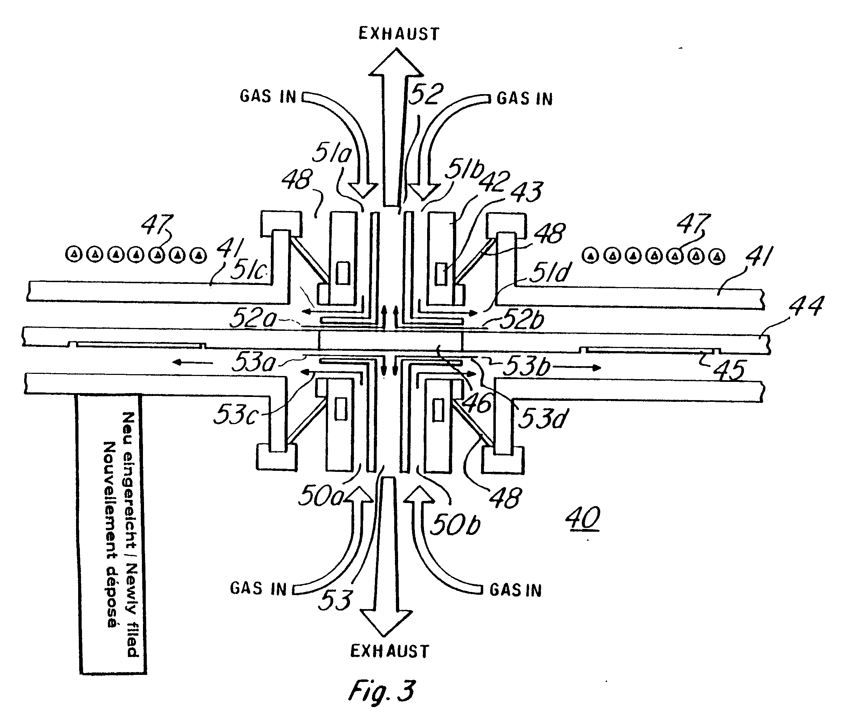

Figure 3 illustrates a typical junction 40 between reactor chambers, showing the input and exhaust gas flow, and the path of the susceptor in the chamber.

Each junction is a metal junction and connects consecutive quartz chambers. Each junction may have either air or water cooled walls with the cooling medium flowing through ducts 43 within the walls. Each junction exhausts the gases from the reactor chambers which it connects. In one embodiment of the invention, alternate junctions are used to introduce process gases into the reaction chamber and in a second embodiment, all junctions are used to introduce gases into the reaction chamber.

As illustrated in Figure 3, gases for the upper portion of the reaction chamber 40 are introduced through into the junction through inlets 51a and 51b, and flows into the reaction chambers through openings 51c and 51d.

Process gases are introduced into the lower portion of the reactor chamber 40 through junction gas inlets 50a and 50b, and the gases flow into the chambers through openings 50c and 50d. The junction serves as a manifold for gas inlets and exhaust outlets.

To exhaust gases from the reaction chamber, the junction uses a combination of the positive pressure of the gas, the slight vacuum in the exhaust manifold, and an adjustable damper (not illustrated) in the exhaust manifold. The pressure of the gases in the reaction chamber results in flow of gas out of the chamber into the junction and into the exhaust outlet. Upper exhaust outlet 52 receives exhaust gases through exhaust inlets 52a and 52b. The lower exhaust outlet 53 receives exhaust gases through exhaust inlets 53a and 53b.

The reaction chamber 41, where the actual reaction occurs, is a generally rectangular quarts chamber. The interior of the quartz chamber is divided into upper and lower sections by the susceptor 44 and spacer 46. The susceptor or wafer carrier slides along two quarts rods or tubes (not illustrated in Figure 3) during indexing of the carrier through the plurality of reactor chambers and through each junction between reactor chambers.

Quartz is used in the chambers to transmit heat from lamps 47 located on at least one side of the reaction chamber. The lamps are used to heat the semiconductor wafer 45 in carrier 44 to the desired reaction temperature.

The semiconductor wafer carriers or susceptors are made of graphite or graphite coated with silicon carbide to withstand the high temperatures of the reaction chambers and to distribute the heat evenly to the wafer being processed.

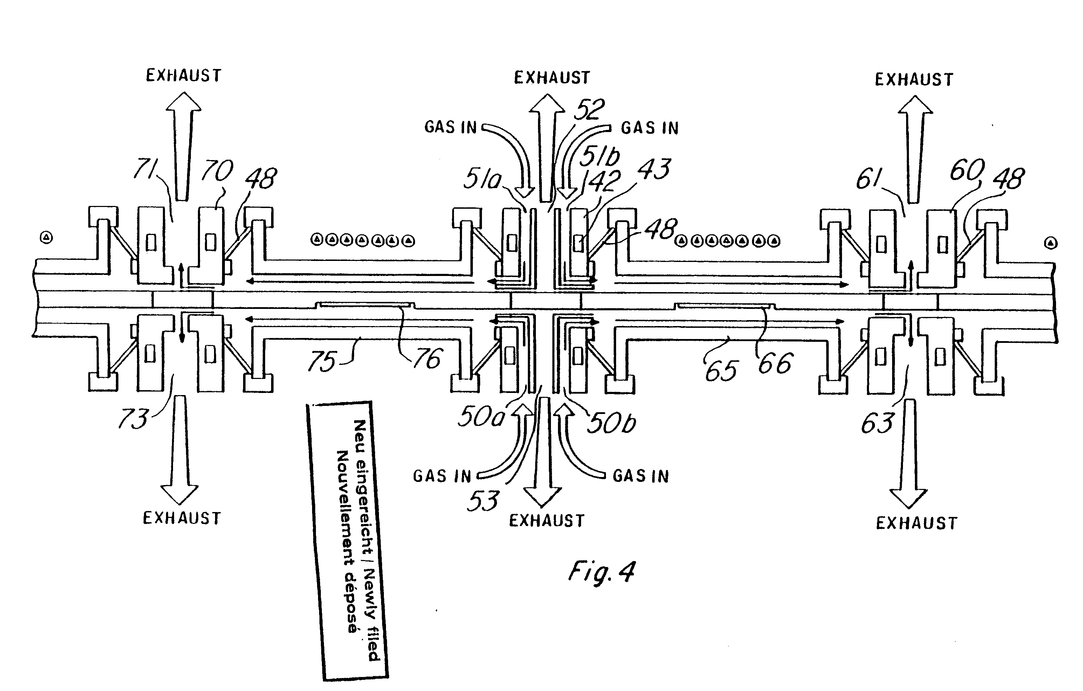

Figure 4 illustrates three junctions and the gas flow from one of the junctions to two other junctions. Junction 42 is the same junction as illustrated in Figure 3. The other two junctions 60 and 70 are different in the respect that they are only exhaust ports, where are no gas inlets. Process gas is introduced into gas inlets 50a and 50b in junction 42. The gas introduced into inlet 50a flows through the reactor, across the surface of semiconductor wafer 75 and exhausts out exhaust port 73 in junction 70. In a similar manner, process gas introduced into gas inlet 50b of junction 42 flows through reactor 65, across the surface of semiconductor wafer 66, and out exhaust port 63 of junction 60. The gas introduced into junction 42 through inlets 51a and 51b also flows through respective reactors 75 and 65. The gas that flows through reactor 75 exhausts through exhaust port 71 in junction 70, and the gas that flows through reactor 65 exhaust through exhaust port 61 in junction 60. The gas flow through the reactors is shown by arrows through the reactors and to the exhaust ports.

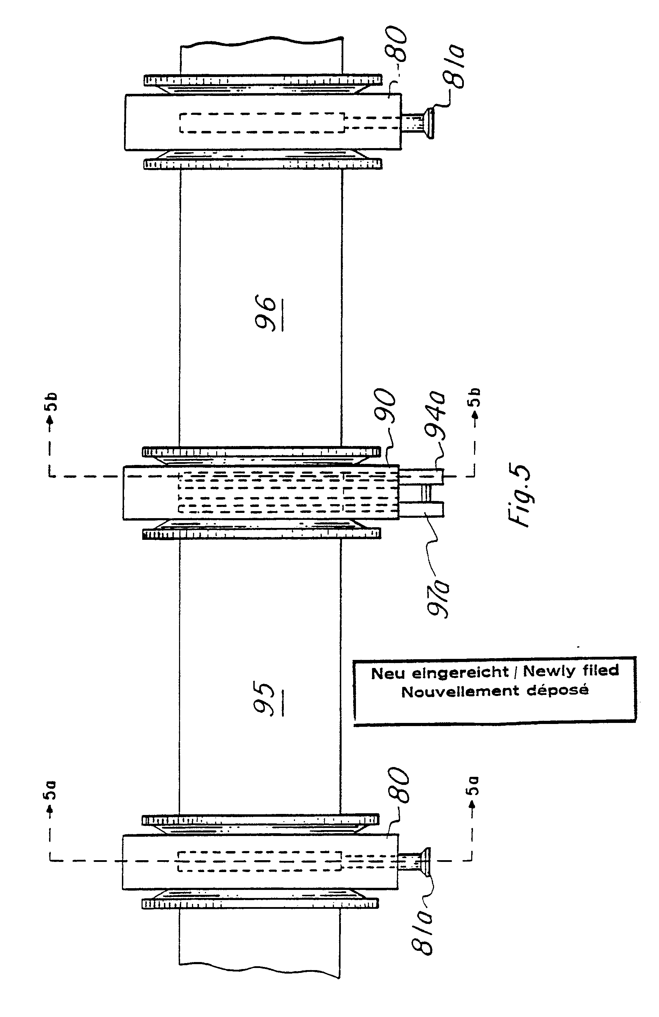

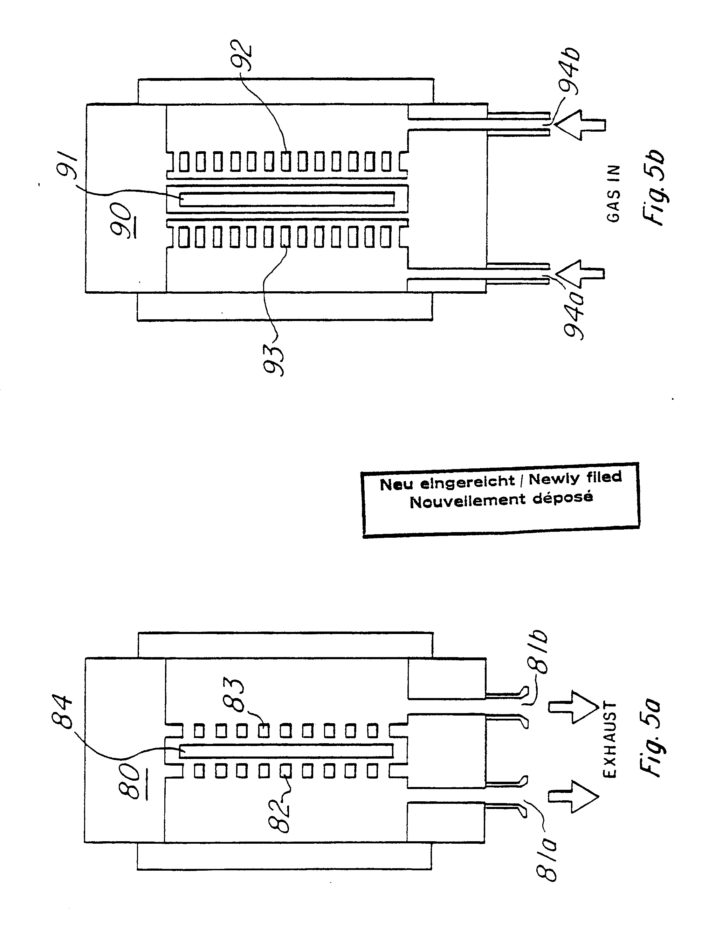

Figures 5, 5a and 5b illustrate an example of the gas inlet and exhaust ports in the reactor chamber junctions. Figure 5 is a top view of two exhaust junctions 80, and one inlet/exhaust junction 90. The three junctions connect reaction chambers 96 and 96. Junction 80 is an exhaust junction connected to reaction chamber 95, and has two exhaust ports, 81a and 81b.

Junction 90 has four gas inlets, only the two 94a and 97a are illustrated in the top view Figure 5. There are four inlets because junction 90 is the gas input junction for both reaction chamber 95 and reaction chamber 96. Gas input in gas inlets 97a, and a gas inlet not shown supply the reaction and process gases to reaction chamber, and gas inlets 94a and 94b (Figure 5b) supply the process gases to reaction chamber 96. The process gases flow through the reaction chambers and exhaust through the exhaust ports 81a and 81b in the exhaust junction 80.

Figure 5b is a cross-sectional view taken through the gas inlets of gas input junction 90. Junction 90 has two rows of gas inlets 92 and 93 on each side of opening 91. Opening 91 is the opening through which the semiconductor carrier passes as the wafer is moved through the several reactor chambers. The semiconductor carrier (not illustrated) divides the reaction chamber into two parts, an upper part and a lower process part. Inlets 92 introduce process gas below the semiconductor carrier, and are evenly spaced to evenly distribute the gas across the surface of the semiconductor wafer since the semiconductor wafer is carried process surface down in the reaction chamber. Inlet 94a introduces an inert gas into the chamber above the carrier and it at a slightly greater pressure than the process gas introduced through inlet 94b to help contain the process gas in the lower process part of the reaction chamber.

Figure 5a illustrates the exhaust outlets 82 and 83. Exhaust outlets 83 exhaust the process gas from the lower part of the reaction chamber, and outlets 82 exhaust the inert gas from the upper part of the reaction chamber.

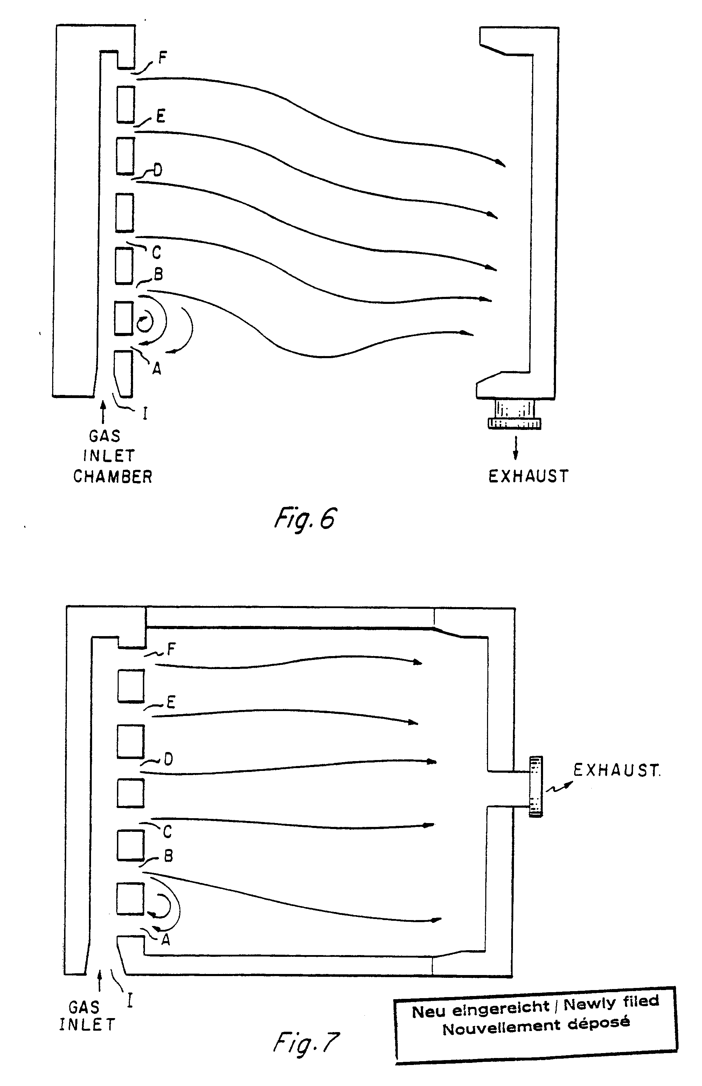

High velocity input of gas into the reaction chamber sometimes causes an uneven distribution of gas across the reaction chamber. Figure 6, a gas flow diagram in the lower or process region of the reactor illustrates a venturi effect of high velocity which causes a recirculation vortex between inlets A and B. Pressure and flow gradually decreases at gas inlet ports C through E as the distance from the gas inlet I increases. Also, the side exhaust port causes a flow of gas diagonally across the chamber.

Figure 7 illustrates gas flow in a reaction chamber using the side gas input as in Figure 6, but with a central exhaust port. The central exhaust port removes the diagonal flow bias, but there is still a recirculation vortex between inlets A and B and a flow gradient from inlet A through F causing most of the process gas to flow through one side, for example inlets A - C.

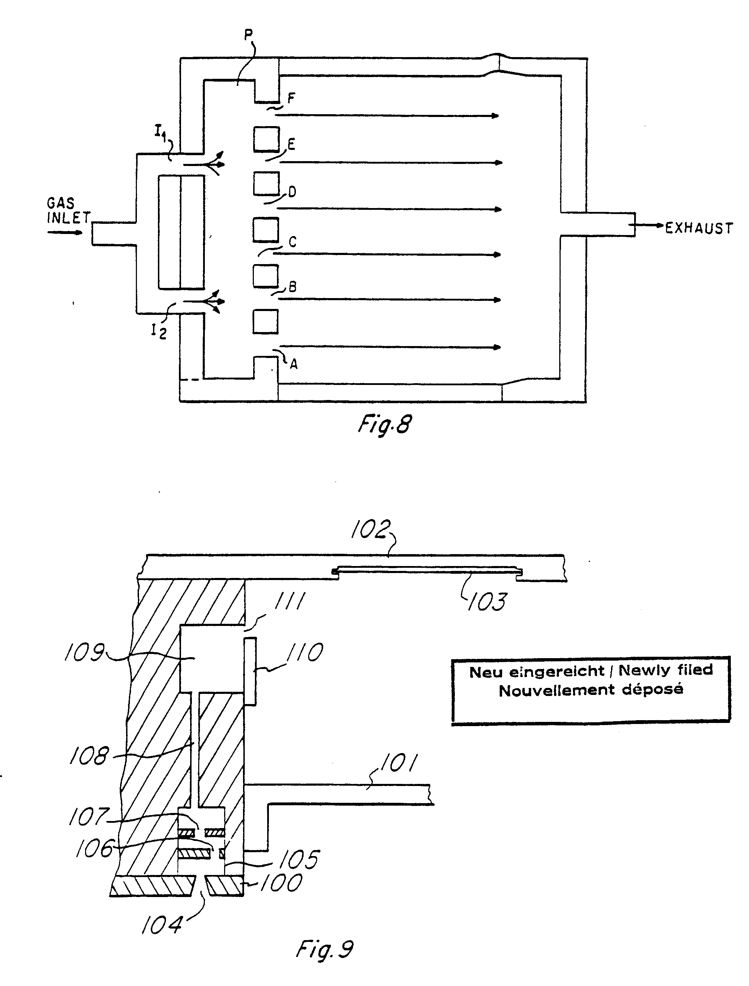

Figure 8 illustrates gas flow in the reaction chamber when the gas inlet I is divided into two inlets $I_1$ and $I_2$, and a central exhaust is used. The two gas inlets cause the gas to be distributed evenly with in plenum P between the gas inlets A through F into the reaction chamber, and the gas has uniform velocities and an even distribution across the process chamber.

Figure 9 illustrates a baffle and shutter system for smoothing out the flow through the reaction chamber. Junction 110 is the gas inlet junction for chamber 101 and the reaction part enclosed by carrier 102 carrying semiconductor 103. Gas is introduced into junction 100 at inlet 104. Gas chamber 105 has two baffles 106 and 107 offset from each other so that there is not a straight through path for the gas.

The gas exits the gas chamber 105 and enters path 108 to gas outlet chamber or plenum 109. The chamber may be one continuous chamber extending across the junction or may be a series of smaller outlets as illustrated in Figures 6-8. The gas outlet 111 into the reaction chamber has a shutter 110 that may be adjusted depending upon the gas pressure/velocity. Shutter 110 is adjusted to provide an even gas flow across the reaction chamber, eliminating vortices and diagonal gas flow.

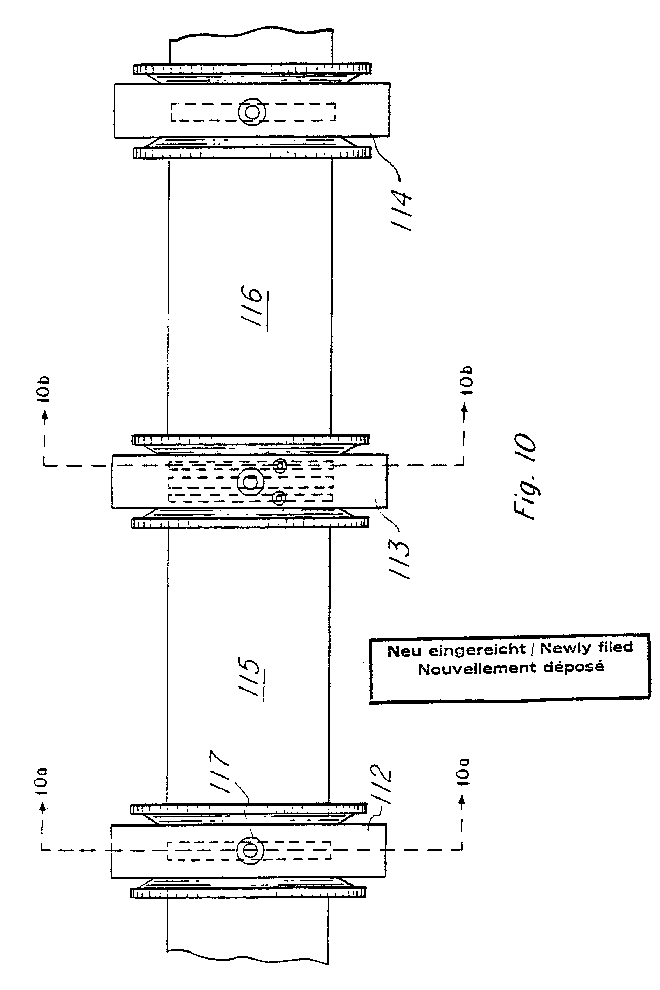

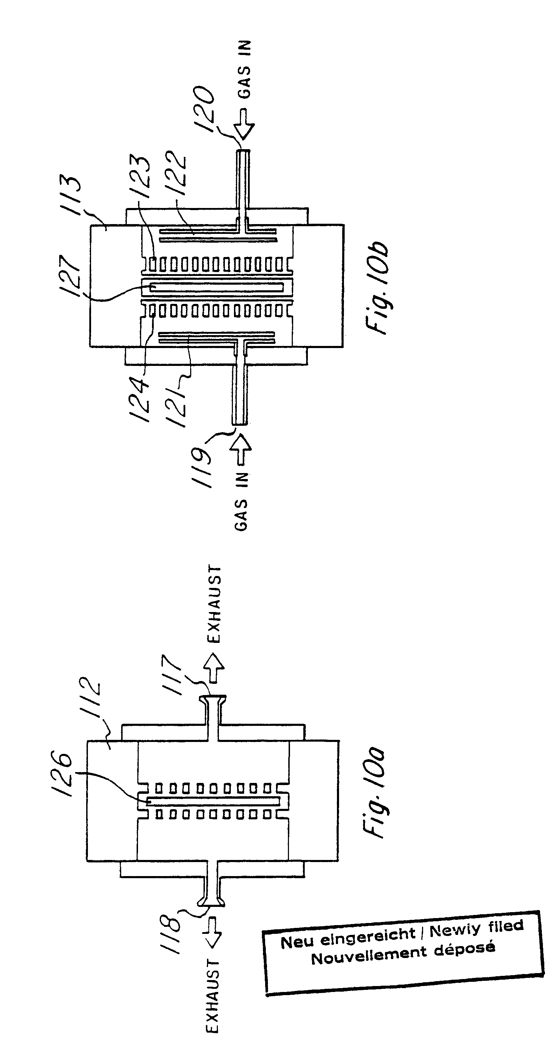

Figure 10 is a top view of two exhaust junctions 112 and 114 joining two reaction chambers 115 and 116 and a process gas input junction 113. The gas input junction and the exhaust junction have center input and output ports.

Figure 10b illustrates the gas input junction 113 which has gas input ports 119 and 120 supplying gas to the reaction part of reaction chambers 115 and 116. Both ports have a baffle 121 and 122 supplying gas to the internal gas outlets 123 and 124. The baffles 121 and 122 perform the function of the baffles in Figures 8 and 9, to provide a even distribution through the reaction chamber. This is accomplished by using the baffled input in conjunction with the center exhaust outlets illustrated in Figure 10a. Exhaust inlets 125 and 126 exhaust through center exhaust outlets 117 and 118 respectively.

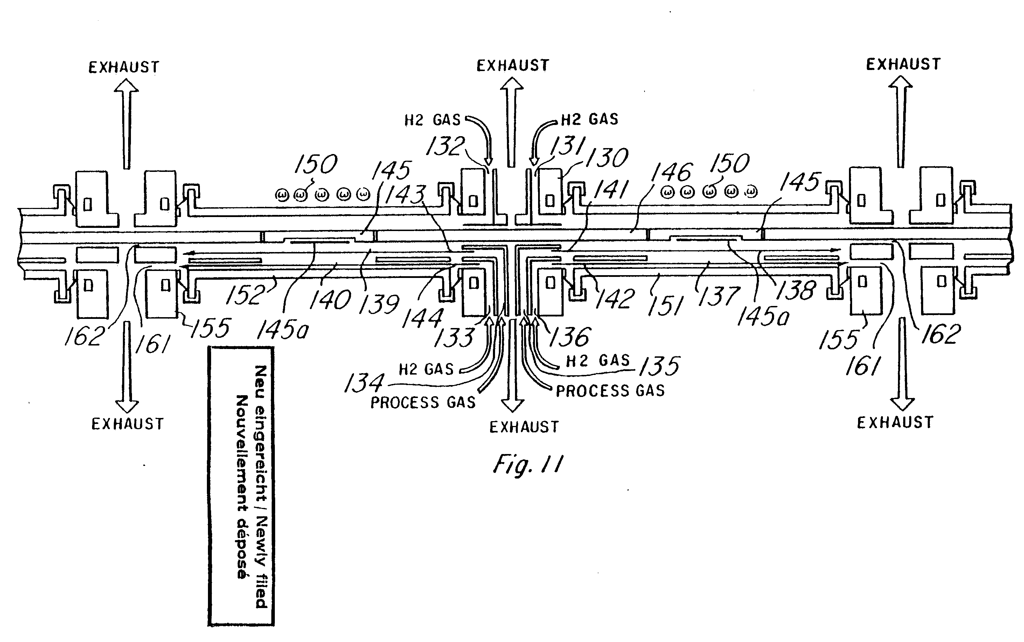

When the process gas flows through the lower part of the reaction chamber during a deposition process, it is not uncommon for material to deposit not only on the semiconductor wafer surface, but also on the bottom of the reactor chamber. This is not desirable since the build up may contaminate the deposition chamber or cause excessive deposits of various deposition material. Figure 11 is a simplified cross-sectional view of a gas input junction, two reaction chambers, and two exhaust junctions, having a gas input structure to prevent deposition of material on the bottom of the deposition chamber.

Gas input junction 130 has two gas inlets 131 and 132 for inputting gas into the top part of the reaction chamber. There are four input gas inlets 133, 134, 135 and 136 for inputting gases into the bottom or process part of the reaction chamber. Process gas is input into reactor 151 through gas inlet 135 and flow though the reactor as indicated by arrow 137. At the same time, $H_2$ or an inert gas is input through inlet 136 and flows through reactor 151 as indicated by arrow 138. The flow of the process gas is parallel to semiconductor 145a in carrier 145 and deposits a desired material on the surface of the semiconductor. At the same time inert gas as indicated by arrow 138 flows parallel to the process gas and the bottom of reactor chamber 151. The laminar flow of the inert gas in between the process gas and the bottom of the reactor chamber prevents material from depositing on the bottom of the reaction chamber.

In a similar, manner gases input into inlets 133 and 134 flow parallel as indicated by arrows 139 and 140 preventing a depositing of material on the bottom of the reaction chamber 152.

The laminar gas flow is continued into exhaust junctions 1255 on each side of gas inlet junction 130 and the two parallel flowing gases exit through two exhaust ports 151 and 152. The pressure of the inert gas may be slightly higher than that of the process gas to prevent a downward flow of the process gas. The actual gas inlets may be structured as the gas inlets illustrated in Figure 10b and the exhaust ports may be structured as in Figure 10a to provide for a evenly distributed gas flow.

Figure 12 illustrates a reactor chamber and semiconductor carrier of the prior art. Reactor chamber 160 has a semiconductor carrier 161 therein. The carrier has a lid 164 and carries a semiconductor wafer 165. The Carrier is constructed to have legs 166 that slide along the bottom 162 of chamber 160 on the bottom 163 of legs 166. There is nothing to prevent the carrier 161 from moving laterally within the chamber, and with the buildup of deposition products on the bottom of the chamber, the movement of the carrier through the chamber may be impeded.

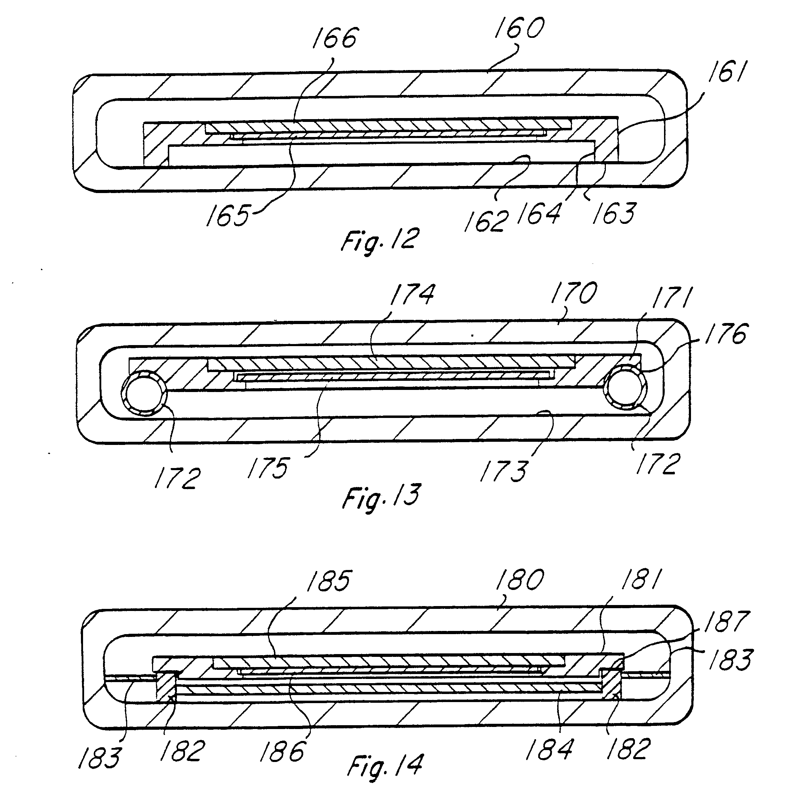

Figure 13 illustrates a carrier track system according to one embodiment of the present invention. Two tubular tracks 172 are positioned within reactor chamber 170. Carrier 171 has circular grooves 176 on each end of the carrier that ride on the circular tracks 172. With this system, the carrier moves smoothly down the tracks and cannot be moved laterally, only linearly down the tracks.

If there is a deposition product build up on the bottom 173 of the chamber 170, it does not affect the movement of the carrier. Carrier 171 has a lid 174 covering the semiconductor wafer 175. Tracks 172, may be solid, or may be tubes, as illustrated, block the process gases from leaving the under side of the carrier, confining the process gases to the area of the chamber under the carrier adjacent the exposed face of semiconductor wafer 175. The tubular tracks may be secured to the deposition chamber by any desired means such as, for example, an adhesive, fusing to the chamber at points adjacent the entrance of each chamber, or by bolts through holes in the tracks. Tracks 172 may be any high temperature material, but are preferable quartz, the same material as the chamber.

To better isolate the process area of the chamber from the other parts of the reaction chamber, tubular tracks 172 may have openings along the under side of the track, and process gas or other gases from then non-process part of the reactor chamber that enter the inside of the tracks are exhausted at openings in the tracks at the reaction chamber-junction interfaces as described below.

Figure 14 is another embodiment of the invention. Reactor chamber 180 has a track therein made up of tracks 182, two side spacers 183 and a central brace 184. With this track system, the track does not have to be secured to the reaction chamber 180 as it will not move laterally to the chamber due to the spacers 183. The spacers 183 and central brace 184 do not extend the full length of the chamber but are place only, for example at the ends of the chamber. Carrier 181 slides along tracks 182 along offset 187. The offset in the carrier prevents the carrier from moving laterally to the tracks 182.

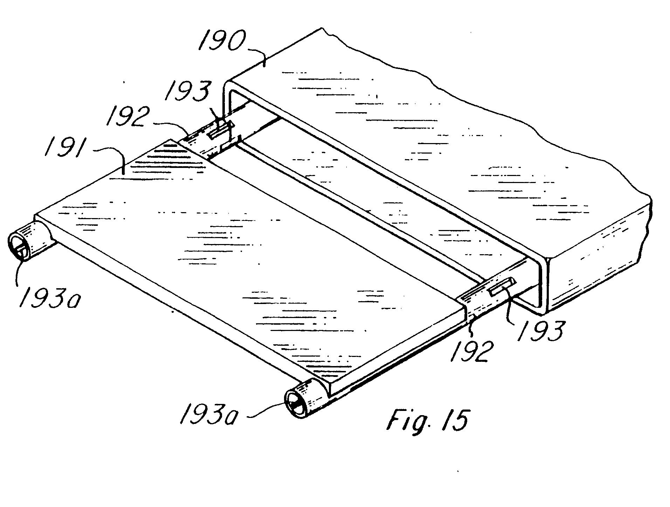

Figure 15 is an isometric view of tracks 192 and chamber 190, with carrier 191 on the tubular tracks. There are openings 143 and 193a in tracks 192. These openings are such that process gases may be exhausted from in between the tracks and under the carrier to the exhaust port in the junctions between reaction chamber. The openings 193a extend along the bottom of the tracks 192 and gases introduced through openings 193a are exhausted at openings 193 at the reaction chamber-junction interface.

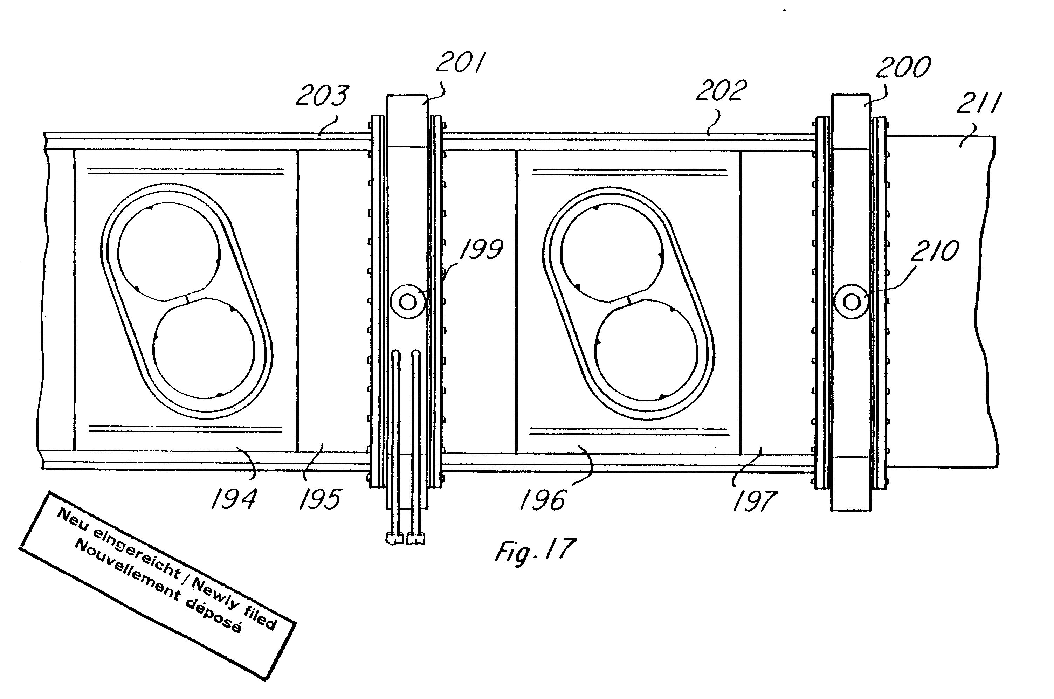

In practice, there are spacers between each carrier so that there is a continuous movement of either spacers or semiconductor carriers on the track through the various chambers of the reactor (see Figure 17).

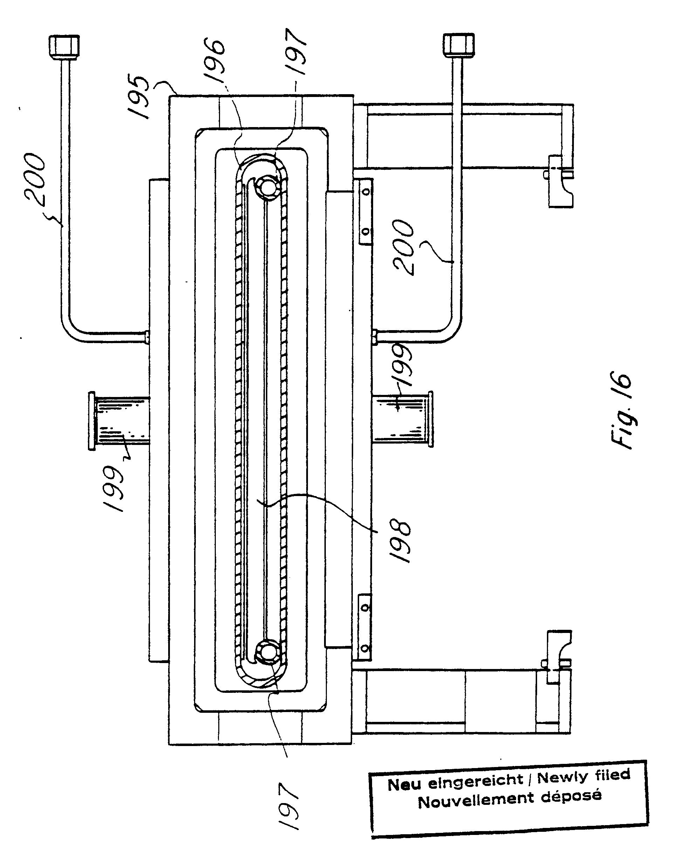

Figure 16 illustrates a typical junction that joins the reaction chambers in the continuous chemical vapor reactor.

Reactor 195 has inlets 200 to introduce process gases into the reaction chambers and exhaust ports 199 to exhaust the spent process gases. The ends of the reaction chambers 196 are connected to the chamber and form a gas seal therewith. The track 197 extends through the junction to provide a continuous track for carriers 198.

Figure 17 illustrates two reaction chambers 202 and 203 connected together by a junction 201. Junction 201 is a process gas input junction as evidenced by gas inlets 208. Junction 201 also has an exhaust port 209, and another exhaust port on the under side (not illustrated, see Figure 16).

Chamber 202 is connected to another chamber by junction 200. Junction 200 is an exhaust junction having an exhaust port 210. Junction 200 has no gas inlets. In practice, gas input junctions are alternated with exhaust only junctions.

In the portion of the reaction chamber illustrate in Figure 17, it may be observed that each semiconductor carrier 204, 206 is spaced apart from the other carrier by a spacer 205, 207. The spacers and carriers are constructed of a size such that as each carrier and adjacent spacer is started through the reactor, the semiconductor carriers are indexed such that the semiconductor wafer in the carrier is centered in each successive chamber until the semiconductor wafer has been indexed in each chamber of the reactor. The semiconductor wafer is then removed. As described in reference to Figure 2. The track system described therein is useful in precisely indexing each semiconductor wafer through the reactor with no wear on the bottom of the reactor chambers, thus prolonging the life of each chamber. The track system may be temporarily removed from chambers so that the chambers may be cleaned.

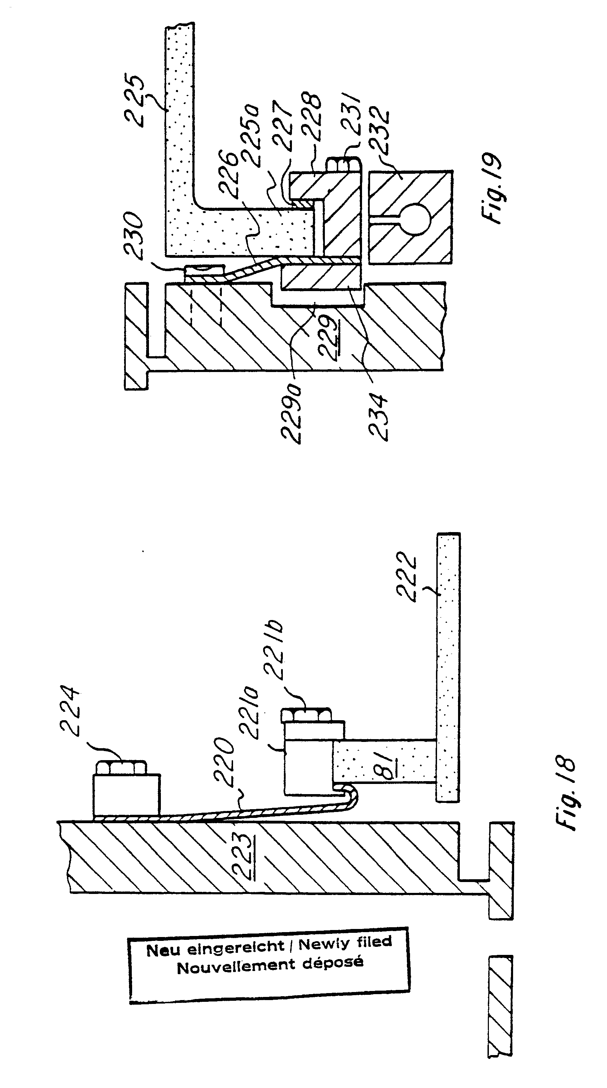

Figure 18 illustrates a method of sealing the interface between the reactor chamber 222 and junction 223 with a flexible seal. Flexible seal 220, which is representative of seal 48 illustrated in Figure 4, is attached to the flange 221 of the reaction chamber 222 with a clamp 221a tightened by bolt 221b. The other end of the seal material is clamped to the junction 223 with bolt-clamp assemble 224. The seal may be any flexible high temperature material, for example silicone. This method of sealing the interface between the junction and reactor chamber provides minimal constrains on the reaction chamber. The use of elastic material allows freedom of motion in all directions and virtually eliminates reactor chamber stress due to mounting and thermal expansion during heating of the reactor chamber.

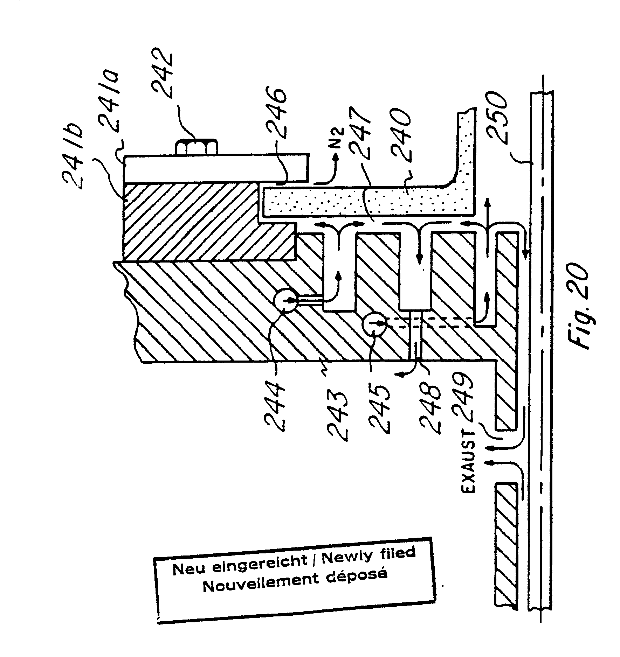

Figure 19 illustrates another embodiment of a flexible seal between the junction and reactor chamber. A seal is formed between junction 229 and quartz chamber 225 by flexible seal 226. One end of the seal is clamped to the flange 225a of chamber 225 by clamp-assemble 228, 231 and 234. The seal is clamped to and held in place by tightening clamp part 234 against seal 230 and clamp part 228 and chamber flange 225a. A cushion/spacer 227 is placed between clamp part 228 and flange 225a to prevent the clamp from bearing directly on the quart chamber flange. The flexible seal 226 is clamped to the junction 229 by screw-clamp 230.

An air bearing support 232 may be used to support the weight of the quartz reaction chamber and the graphite susceptor therein.

A pocket 229a may be provided in junction 229 to nest the clamping flange 234 during assembly and disassembly, and provides clearance for removal of the chamber after outer clamp bolt 230 is removed.

Figure 20 illustrates a method of forming a gas seal between the reactor chamber 240 and the junction 243. The quartz chamber 200 is held against the chamber 243 by clam assembly made up of parts 241b, 241a, and bold 242. The interface 246 between the clamp and the quartz chamber is not a hermetic seal. An inert purge gas such as nitrogen is introduced into gas plenum 244. The nitrogen flows out interface 246 and through opening 247 between the quartz chamber 240 and junction 243 to exhaust port 248. Reactive process gases such as Silane, $H_2$, and HCL are introduced through inlet 245 and flows into the reactor chamber over susceptor 250 and out exhaust port 249 into the exhaust plenum.

The reactive process gas also flows through the reactor chamber to the exhaust at the junction (not illustrated) at the far end of the reaction chamber. The pressure of the inert gas introduced into the junction/chamber interface 247 is greater than that of the reactive gas introduced through inlet 245 such that the reactive gas must flow into the reactor chamber, thus sealing the environment outside the reactor chamber form the reactive gases.

The method of sealing the reactive gases from the environment outside the reactor chamber illustrated in Figure 20 permits completely stress free mounting of the quartz chamber and reduces breakage of the quartz chamber caused by ordinary quartz mounting constraints.

Figures 18, 19 and 20 illustrate only half of the cross section of the junction and quartz chamber. A typical cross-section view of the reaction chambers and junctions are illustrated in Figure 4. The low portion of the junction and quartz chamber illustrated in Figures 18, 19 and 20 have gas seals as illustrated in Figure 18, 19 and 20 such that reactive gases introduced into the quartz chamber below the susceptor is also sealed from the environment around the reactor by the pressure differential between an inert gas and the reactive gases used in the reactor.

The basic steps of processing a semiconductor wafer through the continuous chemical vapor deposition reactor are as follows. Semiconductor wafers are pick-up from a wafer cassette by a robotic arm having a vacuum device thereon and are place in a orientation/centering fixture to orientate the flat side of the semiconductor wafer to a know position. The robotic arm then picks the wafer up and moves it to a carrier. The carrier lid is removed by a vacuum device and the semiconductor wafer is placed in the carrier process side down. The lid of the carrier is replaced over the semiconductor wafer, and the carrier is indexed into the entrance of the reactor. A spacer is placed between each carrier so that as each carrier is indexed into the reactor, each carrier being properly entered and oriented in a reactor chamber. The carrier is indexed the number of times that there are reaction chambers in the reactor. After exiting from the reactor, the carrier is transported to the exit area where the carrier lid is again removed by a vacuum device, the semiconductor wafer is removed by a robotic arm having a vacuum lift mechanism thereon, and the semiconductor is placed in a wafer cassette. The now empty carrier is moved to the reactor entrance area to receive another semiconductor wafer for processing.

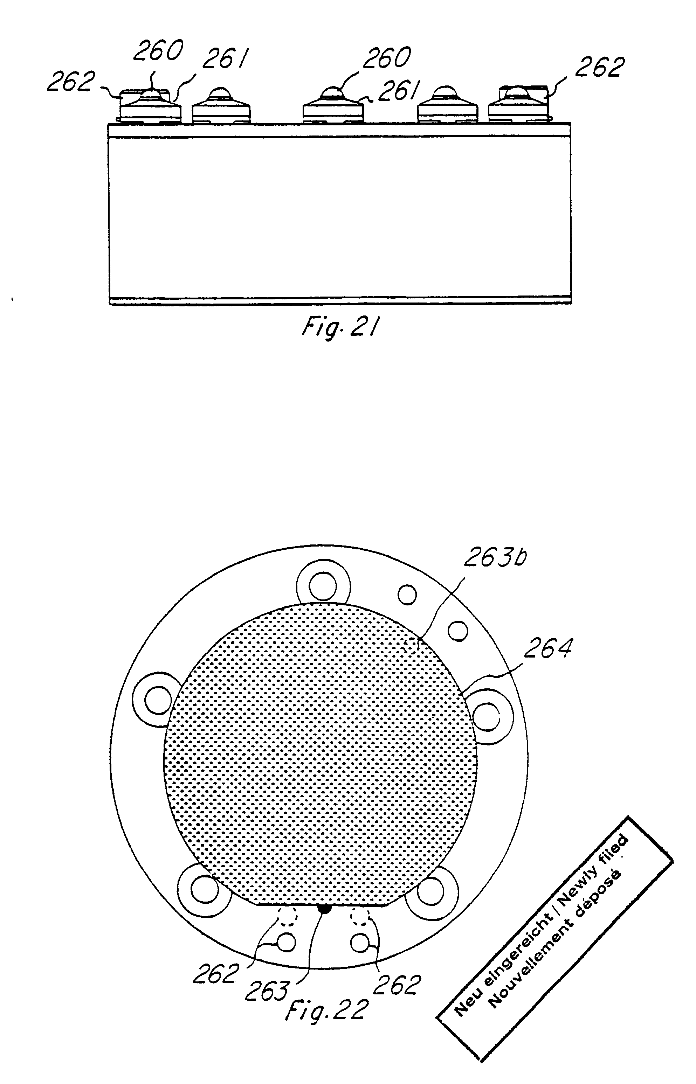

Figures 21 and 22 illustrate a device for centering a semiconductor wafer and finding the flat edge of the wafer There are five rollers having at top roller 260- and a wafer orientation roller 261. There are four rollers 262 that engage the flat side of the wafer and two fiber optic cables 263. A semiconductor wafer 264 is placed down over the rollers 260, 261 such that the edges of the wafer will slide down the tapered surface of top roller 260 and come to rest on the surface of orientation roller 262. When the rollers 261 are rotated, the semiconductor wafer will become centered, and rotation will continue until the flat edge of the semiconductor exposes the end of fiber optic light detector 263. At this time rotation of rollers 261 stops and rollers 262 engage the flat side of the wafer. Rollers 262 are spring loaded so that as the wafer rotates, the round edge of the wafer engages the rollers in a position toward the edge of the centering device, however when the flat part of the device rotates around to the location of the rollers 262, they will be drawn to the flat edge by springs. Rollers 262 move back and forth in slots (not illustrated) and provide the final adjustment or orientation for the wafer. Light impinging on the end of the fiber optic indicates that the flat edge of the wafer is in the location of the fiber optics 263 and that flat edge rollers 262.

Figure 22 shows a semiconductor wafer supported by rollers 261 and centered between the rollers 260. Rollers 262 are illustrated in the extended position 262 in solid lines and retracted positions in dashed lines. Fiber optic end is shown at 263 at the flat edge of the wafer. The end of the fiber optic is shown in dashed lines, under the wafer at the second optical fiber location 263b.

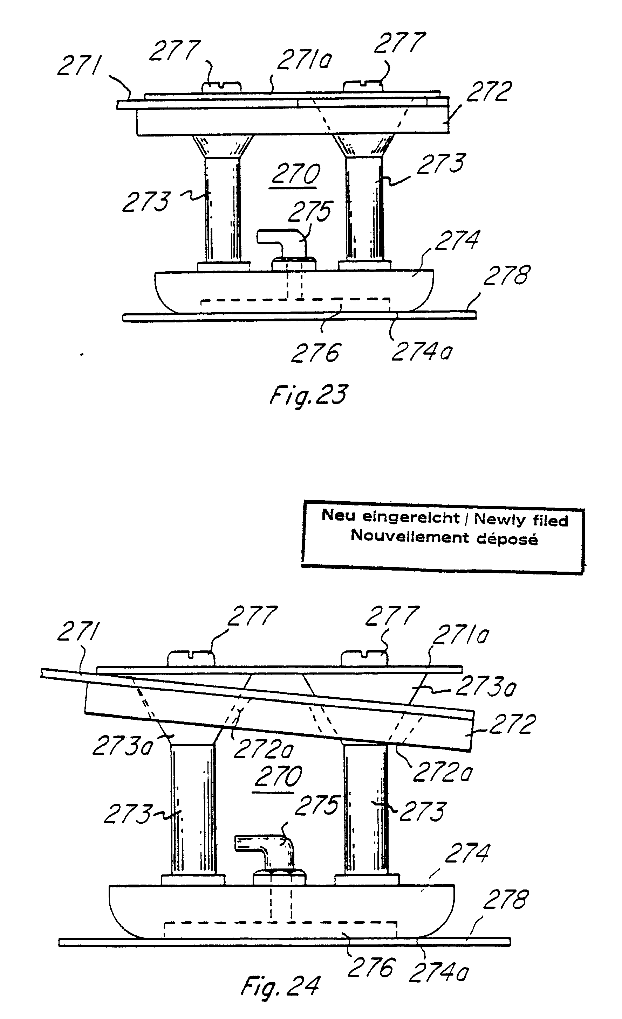

Figures 23 and 24 illustrates the pick mechanism used on the end of a robotic arm to move the semiconductor wafer to be processed to a centering and orientating device. The mechanism 270 is movably mounted on an extension of the robotic arm 271, 272, part 272 being a positioning block in which tapered holes 272a are used to position the conical parts 273a of posts 273. Pick-up device 270 includes two posts, each having one end tapered in a generally conical shape. The two posts 273 are mounted between upper plate 271a and low pick-up device 274. Plate 271a is secured to post 273 by screws 277. The post may be either bonded to or secured to pick-up device 274 by threaded holes (not shown).

Pick-up device 270 has a fitting 275 mounted thereon which attaches to a vacuum source (not illustrated) and opens into vacuum cavity 276 in the bottom surface of pick-up device 274. When pick-up device 274 is lowered into contact with a semiconductor device 278 with a vacuum applied, semiconductor wafer 278 will be drawn up against the bottom surface 274a of pick-up device 274 and held there until the vacuum is removed or released. While the semiconductor device is held against the bottom surface of the pick-up device it may be moved, for example from a loading surface/cassette to the centering and orientating mechanism described below.

Figure 24 illustrates the picking-up of a wafer without placing stress on the wafer, allowing a vacuum to be drawn against the wafer thereby allowing the wafer to be picked-up. In prior art reactor systems, the semiconductor wafer is usually processed face up so that the wafer has to be picked-up by the edge and not by a face of the wafer.

When robotic arm is lowered to pick-up a semiconductor wafer, the bottom surface of the pick-up device comes into contact with the bottom or non-process surface of semiconductor wafer 278. Since the robotic arm is being angled down, the bottom surface 274 does not move parallel into engagement with the surface of the semiconductor wafer. To avoid applying excessive pressure on the surface of the semiconductor wafer, and to permit the entire bottom surface 274a to come into contact with the semiconductor wafer surface, post 273 are not secured to arm 271 and part 272.

The tapered ends 273a of posts 273 reside in tapered holes 272 in robotic arm parts 271 and 272 such that when the arm 271 is lowered and surface 274a comes into contact with the surface of the semiconductor wafer, arm 274 may continue downward a short distant without addition pressure against the semiconductor wafer.

The movement of pick-up device 270 is essentially independent of the movement of arm 271 permitting the lower surface 274a to continue to moved such that it becomes parallel to the surface of the semiconductor wafer, thereby permitting a vacuum to be drawn in vacuum cavity 276, holding and securing the semiconductor wafer to the bottom of the pick-up device.

When arm 271 is raised, the tapered part 273a of post 273 positions the pick-up device to a fixed and known position at the end of robotic arm 271, and therefore positions the semiconductor to a known position. This precise positioning of the pick-up device is important in later proper orienting the semiconductor wafer.

The pick-up device has been shown with two tapered posts 273, however, a single post may be used or, for example three post may be used. As long as the post are tapered, the accurate positioning will take place.

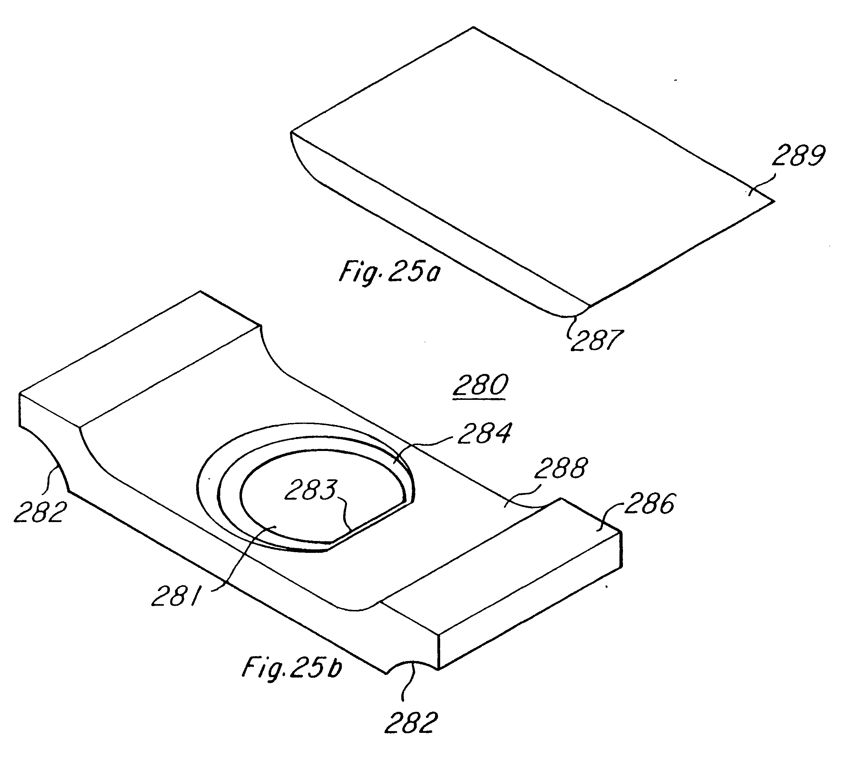

Figure 25 illustrates a semiconductor carrier and lid which may be used in the present invention, however, other designs of carrier may be used. Semiconductor carrier 280 has an opening 281 therein into which is place a semiconductor wafer. The wafer has one flat edge which is used to index or orientate the wafer. Opening 281 also has a flat side 283 to match the flat edge of the semiconductor wafer. It is necessary to orientate the wafer such that the flat of the semiconductor wafer matches the flat of the carrier wafer opening.

Semiconductor support area 284 protrudes from the sides of the bottom of opening 281 to hold the semiconductor in the opening and to expose a maximum of the under side of the wafer, which is the process side of the wafer. Optionally small tabs may extend from the bottom side of opening 281 to support the semiconductor wafer.

The top of carrier 280 has an upper surface 286 and a lower surface 288. The lower surface 248 covers the most of the top surface of carrier 120 and is formed by machining out a portion of the carrier surface to form an opening for lid 289. There is a sloping transition from top surface 286 to lower surface 288 to match the shape of lid 289. Each end of the carrier has a rounded recess 282 which serves as guides to move the carrier along tracks in the reactor (not illustrated).

Lid 289 is used to cover the "up", or back, side of the wafer during processing, and to distribute heat to the semiconductor wafer during processing. The sloping end 287 of the lid matches the sloping transition 290 of the carrier.

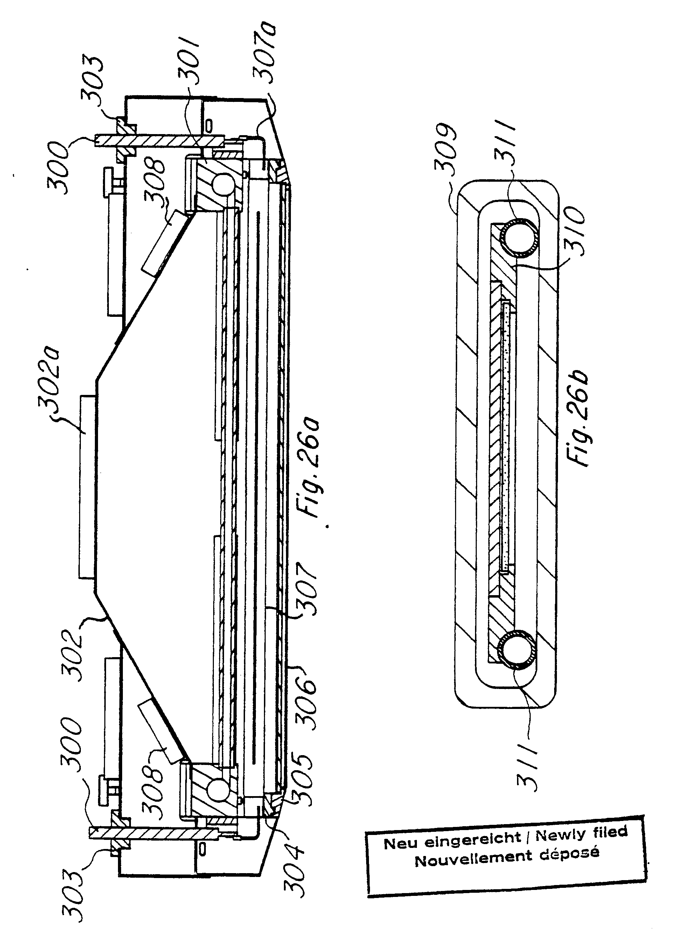

Figure 26 is a cross sectional view of a heating lamp assembly positioned over a reactor chamber. The lamp assembly includes a housing 302 and a hood 302a. A reflector manifold is used for inputting water cooling though the assembly. Lamp 307 is mounted on each end by wires 307a attached to a bus bar 300, which extends through insulator 303 to a point outside the lamp housing. In insulator 304 and retainer 305 hold a quartz shield 306 over the lamps in between the lamps and chamber. There are tow air deflectors 308 on two sides of the lamp housing 302 which direct air flow though the lamp housing for cooling purposes.

The reactor chamber is spaced below the heating assembly is made up basically of a quartz housing, tracks 311 on which carrier 310 is moved through the reactor. Heat from the heating assembly heats the reactor and the semiconductor device (not illustrated) in carrier 4310 to the desired processing temperature. The carrier 310 is indexed through the various reactor chamber on the tracks 311. There is one heating lamp assembly for each reaction chamber in which, for example, an etch or deposition process is performed.

## Claims

1. Process gas inlet and exhaust port structures for use with continuous chemical vapor deposition reactors having junctions between reaction chambers, wherein a junction on one end of the reaction chamber is a gas input junction and a junction on the other end of the reaction chamber is an exhaust junction, comprising:
a gas plenum within the gas input junction having a single input orifice;
a plurality of orifices for distributing gas into the reaction chamber, said plurality of orifices being located on a side of the plenum opposite said single input orifice and positioned to received equal amounts of gas from said input orifice;
an exhaust port in an exhaust junction located at the end of the reaction chamber opposite side input junction, said exhaust port being centrally located in respect to the reaction chamber end adjacent said exhaust junction.

2. The process gas inlet and exhaust port structure according to Claim 1, wherein said gas input orifice has a divided output supplying gas to spaced locations in said gas plenum.

3. The process gas inlet and exhaust port structure according to Claim 1, included a baffled chamber between the gas inlet and the orifices for distributing gas into the reaction chamber.

4. Process gas inlet and exhaust port structures for use with continuous chemical vapor deposition reactors having junctions between reaction chambers, wherein a junction on one end of the reaction chamber is a gas input junction and a junction on the other end of the reaction chamber is an exhaust junction, comprising:
at least two gas plenums within the gas input junction, each having a single input orifice;
a plurality of orifices in each of the two plenums for distributing gas into the two reaction chambers, one on each side of the gas input junction, said plurality of orifices in each plenum being spaced from the single input orifice for that plenum and positioned to receive equal amounts of gas from said input orifice;
an exhaust port in an exhaust junction located at the end of the reaction chamber opposite said input junction, said exhaust port being centrally located in respect to the reaction chamber end adjacent said exhaust junction.

5. Process gas inlet and exhaust port structures for use with continuous chemical vapor deposition reactors having junctions between reaction chambers, wherein a junction on one end of the reaction chamber is a gas input junction and a junction on the other end of the reaction chamber is an exhaust junction, comprising:
a first gas inlet from said gas input junction introducing a process gas into the reaction chamber for processing a semiconductor wafer;
a second gas inlet from said input junction, said second gas inlet being spaced from said first gas inlet to provide a laminar flow of gases from said first and second gas inlets within the reaction chamber.

6. The process gas inlet and exhaust port structure according to Claim 5, wherein a semiconductor wafer is moved through a central region of the reactor face down and the process gas is introduced beneath the wafer for processing the wafer face, and the second gas in introduced below the process gas to prevent deposition of material carried in the process gas on the reactor wall.

7. A method of introducing and exhausting process gases into continuous chemical vapor deposition reactors having junctions between reaction chambers to provide an evenly distribution of gas flow, wherein a junction on one end of the reaction chamber is a gas input junction and a junction on the other end of the reaction chamber is an exhaust junction, comprising the steps of:
introducing gas into a gas plenum in the gas input junction such that the gas flows evenly into the reaction chamber, and exhausting the process gas through a central exhaust port in an exhaust junction.

8. A seal for sealing a chemical reaction chamber from the atmosphere where a reaction chamber is attached to a reaction chamber junction, comprising a flexible diaphragm and a first clamp, with a flange thereon, for clamping a first end of the flexible diaphragm to the reaction chamber, and a second clamp for clamping a second end of the flexible diaphragm to the reaction chamber junction.

9. A seal for sealing a chemical reaction chamber from the atmosphere where a reaction chamber is attached to a reaction chamber junction, comprising a flexible molded diaphragm of silicone material and a first clamp, with a flange thereon, for clamping a first end of the flexible diaphragm to the reaction chamber, and a second clamp for clamping a second end of the flexible diaphragm to the reaction chamber junction.

10. A seal for preventing reactive gas flow out of a chemical reaction chamber to the atmosphere at the interface where a reaction chamber is attached to a reaction chamber junction, comprising a first gas inlet for introducing reaction gas into the reaction chamber at a desired gas pressure, a second gas inlet positioned to introduce a second gas into the reaction chamber/reaction chamber junction interface between the first gas inlet and said interface, said second gas being introduced into said interface at a pressure greater than the pressure of said reaction gas, thereby preventing the reaction gas from flowing into said interface and escaping from the reactor.

11. A seal for preventing reactive gas flow out of a chemical reaction chamber to the atmosphere at the interface where a reaction chamber is attached to a reaction chamber junction, comprising a first gas inlet for introducing reaction gas into the reaction chamber at a desired gas pressure, a second gas inlet positioned to introduce a second inert gas into the reaction chamber/reaction chamber junction interface between the first gas inlet and said interface, said first gas inlet and the second gas inlet are located in the reaction chamber junction, and said second gas being introduced into said interface at a pressure greater than the pressure of said reaction gas, thereby preventing the reaction gas from flowing into said interface and escaping from the reactor.

12. A method for preventing reaction gases within a reaction chamber from escaping to the atmosphere through there sealess interface between the reaction camber and the junctions connecting successive reaction chambers, comprising the steps of;

introducing a reaction gas through a first gas inlet into the reaction chamber at a desired pressure, and

introducing a second gas through a second gas inlet into the sealess interface between the reaction chamber and the reaction chamber junction, said second gas being introduce at a pressure higher that the reaction gas.

13. A method for preventing reaction gases within a reaction chamber from escaping to the atmosphere through the sealess interface between the reaction chamber and the junctions connecting successive reaction chambers, comprising the steps of introducing a reaction gas throug a first

gas inlet into the reaction chamber at a desired pressure,

introducing a second gas through a second gas inlet into the sealess interface between the reaction chamber and the reaction chamber junction, said second gas being introduce at a pressure higher that the reaction gas; and

exhausting the a portion of said second gas and a portion of said first gas through an exhaust port located between said first gas inlet and said second gas inlet.

14. A continuous chemical vapor deposition reactor comprising:

a plurality of reaction chambers;

a plurality of junctions joining the reaction chambers together in series;

a plurality of heating assemblies, there being one heating assembly over selected ones of the reaction chambers;

a plurality of semiconductor carriers for moving semiconductor wafer through the reactor; and

a continuous track extending through the plurality junctions and reaction chambers providing means on which the semiconductor wafer carriers are guided through the reactor.

15. A continuous chemical vapor deposition reactor comprising:

a plurality of reaction chambers;

a plurality of junctions joining the reaction chambers together in series and from introducing and exhausting gases from each reaction chamber;

a plurality of heating assemblies, there being one heating assembly over selected ones of the reaction chambers, a plurality of semiconductor wafer carriers for moving semiconductor wafers through the reactor;

a robotic arm for loading semiconductor into the semiconductor wafer carriers; and

a continuous track extending through the plurality junctions and reaction chambers providing means on which the semiconductor wafer carriers are guided through the reactor.

16. A semiconductor carrier and track system for transporting semiconductor wafers through a reactor system, comprising the combination of:

one or more reaction chambers;

a pair of guide tracks spaced to accept the grooves along two sides of said semiconductor wafer carrier;

wherein said guide tracks are removably mounted in said one or more reactor chambers for moving said semiconductor carriers through the reactor system.

17. A semiconductor carrier and track system for transporting semiconductor wafers through a reactor system, comprising the combination of:

two or more quartz reaction chambers joined by junctions;

a semiconductor wafer carrier having grooves along two sides of the carrier; and

a pair of quartz guide tracks spaced to accept the grooves along two sides of said semiconductor wafer carrier;

wherein said guide tracks are removably mounted in said two or more reactor chambers for moving said semiconductor carriers through the reactor system.

18. The combination according to Claim 17, wherein the guide tracks have openings therein at spaced intervals for exhausting the process gas from under the semiconductor carrier and for preventing gases outside the area under the semiconductor carrier..

19. The combination according to Claim 17, wherein reaction chambers are joined at gas inlet junctions and exhaust junctions, and the gases entering the guide tracks are exhausted at the junctions.

Fig. 1

15

14

14

14

14

14

14

14

17

18

12

16

11

10

29

27

30

37

25

24

25a

31

32

36

33

34

21a

22

23

21

20

*Fig.2*

EP 0 378 815 A2

EXHAUST

GAS IN — 52 — GAS IN

51a

48  51b 42 43

47  41  48

47  41

51c  51d  44

52a  52b

53a  53b  45

53c  46  53d

48  40

50a  50b

53

GAS IN — 53 — GAS IN

EXHAUST

Fig. 3

EP 0 378 815 A2

Fig.4

Neu eingereicht / Newly filed
Nouvellement déposé

Fig.5

EP 0 378 815 A2

84

80

83

82

81a    81b

⬇    ⬇

EXHAUST

Fig. 5a

91

90

93    92

94a ⬆    ⬆ 94b

GAS IN

Fig. 5b

EP 0 378 815 A2

F
E
D
C
B
A
I

GAS
INLET
CHAMBER

EXHAUST

Fig. 6

F
E
D
C
B
A
I

GAS
INLET

EXHAUST.

Fig. 7

Neu eingereicht / Newly filed
Nouvellement déposé

EP 0 378 815 A2

Fig.8

Neu eingereicht / Newly filed
Nouvellement déposé

Fig.9

→ 10a

→ 10b

*117*

*115*

*116*

*112*

*113*

*114*

→ 10a

→ 10b

*Fig. 10*

EP 0 378 815 A2

Fig. 10b

Fig. 10a

GAS IN
GAS IN
120
122
123
113
127
124
121
119
EXHAUST

112
117
126
118
EXHAUST

Fig. 11

EP 0 378 815 A2

Neu eingereicht / Newly filed
Nouvellement déposé

EP 0 378 815 A2

Fig. 12

Fig. 13

Fig. 14

Neu eingereicht / Newly filed
Nouvellement déposé

Fig. 15

EP 0 378 815 A2

Fig. 16

Fig. 17

EP 0 378 815 A2

Neu eingereicht / Newly filed
Nouvellement déposé

224

220

223

221a

221b

81

222

Fig. 18

230

225

226

225a

227

228

229a

229

231

234

232

Fig. 19

EP 0 378 815 A2

241b
241a
242
246
N2
247
240
250
244
243
245
248
EXAUST 249

Fig. 20

Fig. 21

Fig. 22

Neu eingereicht / Newly filed
Nouvellement déposä

EP 0 378 815 A2

Fig.23

Neu eingereicht / Newly filed
Nouvellement déposé

Fig. 24

Fig. 25a

Fig. 25b

Fig. 26a

Fig. 26b

EP 0 378 815 A2